# EUROPEAN PATENT SPECIFICATION

(11) **EP 1 214 764 B1**
(45) Date of publication and mention of the grant of the patent: **07.05.2003**
(21) Application number: 00958866.6
(22) Date of filing: 08.09.2000
(51) Int. Cl.: H01S 5/22, H01S 5/12

(54) **SEMICONDUCTOR LASER DIODE WITH A DISTRIBUTED REFLECTOR**
HALBLEITERLASERDIODE MIT VERTEILTEM REFLEKTOR
DIODE LASER A SEMI-CONDUCTEUR AVEC REFLECTEUR REPARTI

(30) Priority: 08.09.1999 GB 9921445
(43) Date of publication of application: 19.06.2002
(73) Proprietor: UNIVERSITY OF BRISTOL, Bristol BS8 1TH (GB)
(72) Inventor: MASSARA, Aeneas Benedict, Colchester, Essex CO6 3EA (GB); SARGENT, Laurence John, Marlow, BUCKS SL7 3BU (GB); PENTY, Richard Vincent, Bristol BS6 6AG (GB); WHITE, Ian Hugh, Weston, Bath BA1 3NH (GB)
(74) Representative: O'Connell, David Christopher
(86) International application number: GB0003483
(87) International publication number: WO01018924

(56) References cited:
- JP-A- 2 143 581
- JP-A- 10 098 235
- US-A- 5 684 817
- MASSARA A B ET AL: "Mode-hop-free, singlemode operation of 2D lattice distributed reflector laser under 2.5 Gbit/s modulation" ELECTRONICS LETTERS, 20 JAN. 2000, IEE, UK, vol. 36, no. 2, pages 141-142, XP002154423 ISSN: 0013-5194
- HAN H ET AL: "TWO-DIMENSIONAL RECTANGULAR LATTIVE DISTRIBUTED FEEDBACK LASERS: A COUPLED-MODE ANALYSIS OF TE GUIDED MODES" IEEE JOURNAL OF QUANTUM ELECTRONICS,US,IEEE INC. NEW YORK, vol. 31, no. 11, 1 November 1995 (1995-11-01), pages 1947-1954, XP000541540 ISSN: 0018-9197
- MEIER M ET AL: "LASER ACTION FROM TWO-DIMENSIONAL DISTRIBUTED FEEDBACK IN PHOTONIC CRYSTALS" APPLIED PHYSICS LETTERS,US,AMERICAN INSTITUTE OF PHYSICS. NEW YORK, vol. 74, no. 1, 4 January 1999 (1999-01-04), pages 7-9, XP000804554 ISSN: 0003-6951
- MILLER L M ET AL: "A DISTRIBUTED FEEDBACK RIDGE WAVEGUIDE QUANTUM WELL HETEROSTRUCTURE LASER" IEEE PHOTONICS TECHNOLOGY LETTERS,US,IEEE INC. NEW YORK, vol. 3, no. 1, 1991, pages 6-8, XP000202985 ISSN: 1041-1135
- YOSHIAKI WATANABE ET AL: "LATERALLY COUPLED STRAINED MQW RIDGE WAVEGUIDE DISTRIBUTED-FEEDBACKLASER DIODE FABRICATED BY WET-DRY HYBRID ETCHING PROCESS" IEEE PHOTONICS TECHNOLOGY LETTERS,US,IEEE INC. NEW YORK, vol. 10, no. 12, December 1998 (1998-12), pages 1688-1690, XP000802155 ISSN: 1041-1135
- IMADA M. ET AL.: 'Semiconductor lasers with one- and two-dimensioal air/semiconductor gratings embedded by wafer fusion technique' IEEE JOURNAL OF SELECTED TOPICS IN QUANTUM ELECRONICS vol. 5, no. 3, May 1999, pages 658 - 663, XP000930544
- BULLOCK D.L. ET AL.: 'Photonic band structure investigation of two-dimensional Bragg reflector mirrors for semiconductor laser mode control' JOURNAL OF THE OPTICAL SOCIETY OF AMERICA - B vol. 10, no. 2, 01 February 1993, pages 399 - 403, XP000606814

## Description

Laser devices are commonly used as light sources, and it is of particular interest to be able to obtain laser sources which have high quality spectral performance for data communication applications. It is of particular interest to be able to manufacture such devices in a relatively simple and low cost way, to achieve a robust device. In particular it is advantageous to achieve a device with a highly selective optical spectrum, that is, a device which produces a large amplitude peak at one specific wavelength of output light.

One type of laser device which can be used as such a source is a Distributed Feedback (DFB) laser, and the related Distributed Bragg Reflector (DBR) laser. However, conventional techniques for manufacturing such devices include regrowth steps, which make the manufacturing relatively expensive.

The paper "1.5µm wavelength DBR lasers consisting of 3λ/4-semiconductor and 3λ/4-groove buried with benzocyclobutene", M.M.Raj, J. Wiedmann, Y. Saka, H. Yasumoto and S. Arai. *Electronics Letter, Vol*.. *35, No. 16*, *pp. 1335-1337* describes a method of manufacturing deep etched (DBR) lasers. Since this technique involves etching into and across the active layer, the wave ceases to be guided within the etch, which means that these devices are likely to be inherently lossy.

A laser device, with a ridge waveguide, with a distributed reflector on either side of the central ridge, is disclosed in JP 10 098 235 A.

The present invention relates to a laser device with a ridge waveguide, with a distributed reflector on either side of the central ridge whereby the reflector takes the form of a two-dimensional pattern as defined by the appended claims 1-21. This allows efficient reflection, while allowing the reflector to be contained in a relatively short length of the device.

For a better understanding of the present invention, and to show how it may be put into effect, reference will now be made, by way of example, to the accompanying drawings, in which:-
Figure 1 is a plan view of a laser device in accordance with the invention.
Figure 2 is an enlarged schematic illustration of a region of Figure 1.
Figure 3 is a cross-sectional view through the device of Figure 1.
Figure 4 illustrates the room temperature (20°C) CW optical spectra at 60mA for (a) pre-etch non-AR coated and (b) post-etch AR coated conditions of the device of Figure 1.
Figure 5 illustrates the post-etch room temperature (20°C) CW L-I characteristics of the device of Figure 1.
Figure 6 illustrates the post-etch, room temperature (20°C) variation of lasing wavelength with CW bias current for the device of Figure 1.

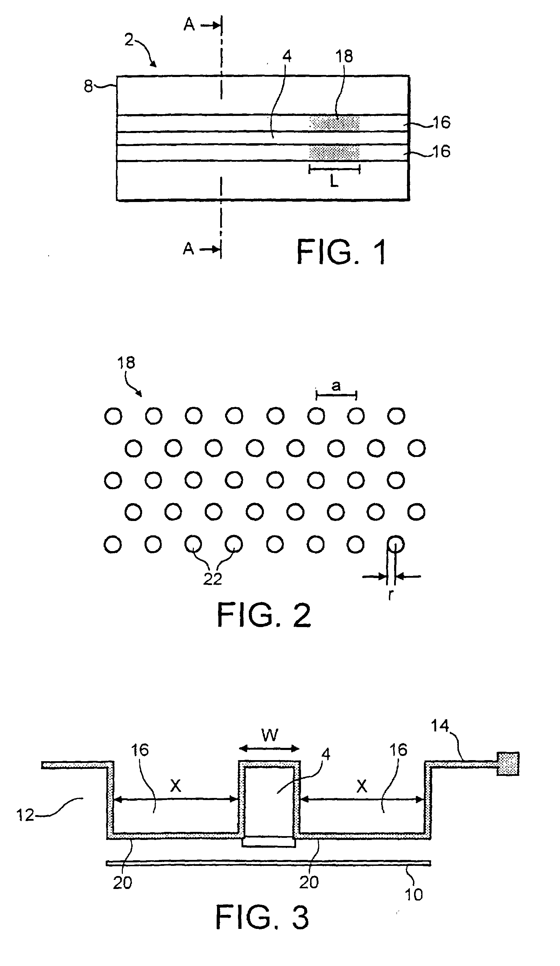

Figure 1 is a top plan view of a laser device in accordance with the invention. The device 2 is an InGaAsP-InP laser, with a ridge-waveguide 4. The device consists of seven 0.8% compressively strained quantum wells, and operates at a centre wavelength of ∼1.29µm. The laser is 350µm long, and acts as a Fabry-Perot (F-P) laser. It is cleaved on both end facets 6,8. The laser is bonded junction side up on a temperature-controlled submount (not shown) and the output can be connected via a lensed fibre. The back facet 6 is AR coated to 0.1%, in order to suppress the F-P modes.

Figure 3 is a cross-sectional view, taken on line A-A in Figure 1. As shown in Figure 3, the device has an active region 10 within the structure, with a silicon dioxide layer 12, having a metal layer 14 above it as the uppermost layers. The central ridge-waveguide has a width W of, for example, approximately 3µm, with etched channels of width X of approximately 8µm on either side of the ridge waveguide.

In accordance with the preferred embodiment of the invention, a distributed reflector structure is provided on either side of the central ridge waveguide, leaving the waveguide itself untouched.

In this illustrated embodiment of the invention, the distributed reflectors take the form of an etched 2D-lattice grating 18. The grating 18 is etched into the bottom surfaces 20 of the channels 16, over a section of the cavity. This section has a length L of approximately 50µm, and is located towards the back facet 6 of the device, for example approximately 50µm from the back facet.

Figure 2 is an enlarged view of the etched grating pattern in one of the channels 16. The array comprises a series of holes 22, etched through the top contact 14 to a depth which is comparable to the depth of the active region 10. In this illustrated embodiment, the holes 22 are arranged in a hexagonal array. That is, each hole away from the edge of the array is surrounded by six equally spaced holes. This separation a is of the order of 0.60-0.65µm, and the holes have a radius r such that the radius-to-pitch ratio r:a is 0.17, although it may be in the range of 0.17-0.33.

The grating pattern could also be a square array, or any pattern which provides a suitable reflector.

Preferably, the holes are etched to a depth which is very close to, or, more preferably, into the active region.

Advantageously, the holes can be obtained by post-processing using any available etching technique, for example, focused ion bean etching (FIBE)or reactive ion etching (RIE), without requiring any subsequent regrowth. This has the advantage that the device can be manufactured relatively simply and inexpensively.

This structure has the further advantage that the holes, which act as the reflectors, provide a high refractive index contrast ratio between the holes and the material of the device, of approximately 1:3.5.

In order to improve passivation, it is possible to fill in the etched holes with a suitable material, such as benzocyclobutene (BCB), which reduces this ratio to approximately 1.5:3.5. However, this ratio is sufficiently large that a highly selective characteristic can be obtained, over a short etched length.

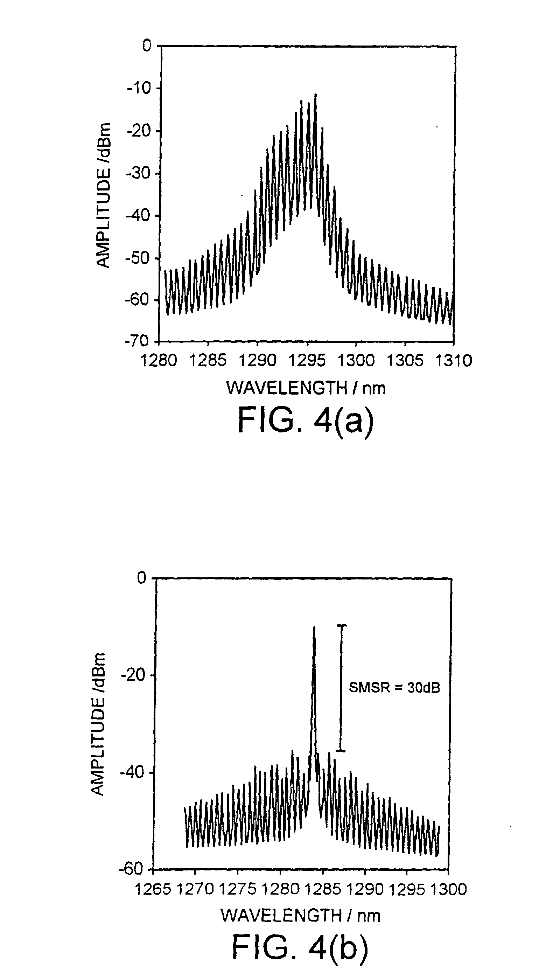

The post-etch performance of the device is characterised in terms of the optical spectra. Measurements are taken at room temperature (20°C) under CW bias conditions. Figure 4a shows the pre-etch spectrum before AR coating at 60mA. This is indicative of a typical multi longitudinal mode F-P structure. Figure 4b illustrates clearly that, after etching, the device lases in a single longitudinal mode. Purely single mode operation is maintained over the entire operating current range up to over 3 times threshold. A typical SMSR value of >30dB is measured.

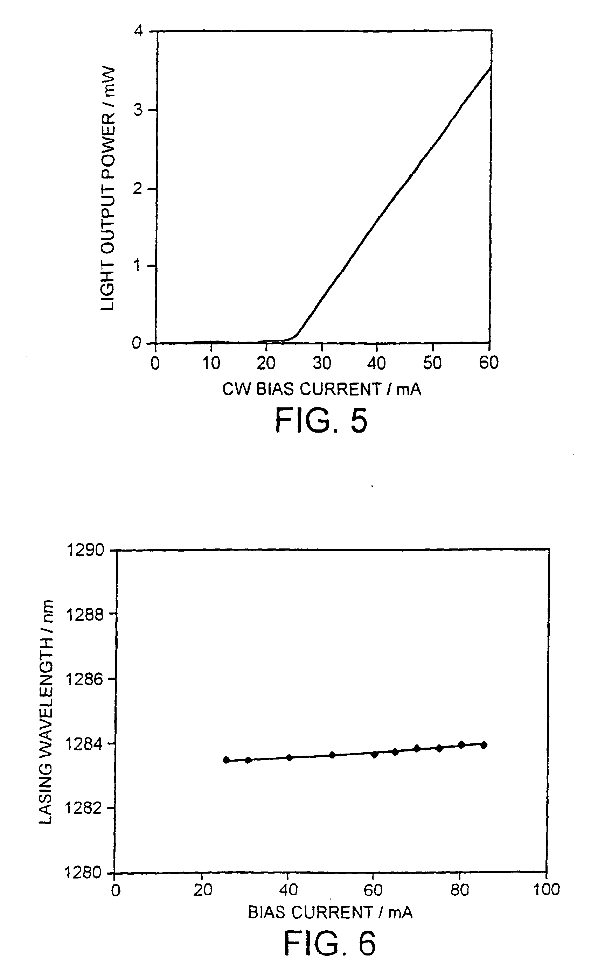

In order to investigate the stability of the lasting wavelength, the light current characteristics under CW bias conditions are measured at room temperature. Figure 5 shows a linear response above threshold, with no kinks evident, indicating that mode-hopping does not occur. A slope efficiency of 0.09 W/A is measured along with an output power of greater than 2.5mW at twice threshold current. At room temperature, a reduction in threshold current of 2mA was observed as a result of the etch.

Single mode operation is further evidenced in Figure 6, which shows the variation of peak wavelength with CW bias current at room temperature (20°C). From threshold up to 85mA, the lasing wavelength is found to vary linearly at 0.009nm/mA, indicating mode-hop-free operation. The device spectra remain,single mode over this range. Single mode emission is found to vary at the rate of 0.08nm/°C around room temperature.

One possible use of the device of the invention is in an integrated device which has, say, four such laser sources on a single device, with the distributed reflector structures of the four sources being different, such that the integrated device can selectively provide a source at any of four wavelengths.

There is thus described a technique which allows manufacture of a single-contact, mode-hop-free single longitudinal mode laser operating CW at room temperature, and bit rates up to approximately 10 GHz, to be produced from a previously multi-mode Fabry-Perot ridge-waveguide device.

## Claims

1. An optical device, comprising a laser diode (2) having a ridge waveguide (4) located above an active layer (10), and having a distributed reflector (18) **characterized in that** the distributed reflector is in the form of a lattice of individual elements (22), wherein the elements are arranged in a two-dimensional array (18) on either side of the ridge waveguide (4).

2. An optical device as claimed in claim 1, wherein the distributed reflector (18) comprises a structure in material above the active layer (10) on either side of the ridge waveguide (4).

3. An optical device as claimed in claim 1 or 2, wherein the two-dimensional array (18) is in a plane parallel to the active layer (10) and extends to a depth comparable to that of the active layer (10).

4. An optical device as claimed in claim 1, 2 or 3, wherein the individual elements (22) are holes.

5. An optical device as claimed in claim 4, wherein the holes (22) are arranged in a hexagonal array.

6. An optical device as claimed in claim 4, wherein the holes (22) are arranged in a square array.

7. An optical device, as claimed in one of claims 4 to 6, wherein the holes (22) extend to a depth comparable to that of the active layer (10) in a direction that is perpendicular to the plane parallel to the active layer (10).

8. An optical device, as claimed in one of claims 4 to 6, wherein the holes (22) extend to a depth comparable to that of the active layer (10) in a direction that is not perpendicular to the plane parallel to the active layer (10).

9. An optical device, as claimed in one of claims 4 to 8, wherein the holes (22) are regions of different refractive index to that of the device structure.

10. An optical device, as claimed in one of claims 4 to 9, wherein the holes (22) are regions of different gain or loss to that of the device structure.

11. An optical device, as claimed in one of claims 3 to 10, wherein the distributed reflector (18) does not pierce the active region (10).

12. An optical device, as claimed in one of claims 3 to 10, wherein the distributed reflector (18) partially pierces the active region (10).

13. An optical device, as claimed in one of claims 3 to 10, wherein the distributed reflector (18) fully pierces the active region (10).

14. An optical device, as claimed in any preceding claim, wherein the distributed reflector (18) is within the device.

15. An optical device, as claimed in claim 14, wherein the distributed reflector (18) is within a pumped region.

16. An optical device as claimed in claim 14, wherein the distributed reflector (18) is within an unpumped region.

17. An optical device as claimed in any preceding claim, with means for varying the electrical bias or biases applied to the device to obtain efficient optical emission in single wavelength operation.

18. An optical device, as claimed in claim 17, wherein the emission wavelength may be controlled/tuned.

19. An optical device, as claimed in any preceding claim, which is integrated with separate amplifying, absorbing or passive sections.

20. An optical device, as claimed in claim 19, where the amplifying or absorbing sections have gain/loss modulation.

21. An optical device, as claimed in any preceding claim, with means for being pulsed by gain switching, Q-switching or mode-locking techniques.

## Patentansprüche

1. Optische Vorrichtung, aufweisend eine Laserdiode (2) mit einem Stehgkohlleiter (4), der sich oberhalb einer aktiven Schicht (10) befindet, und einen verteilten Reflektor (18), **dadurch gekennzeichnet, dass** der verteilte Reflektor in Form eines Gitters individueller Elemente (22) vorliegt, wobei die Elemente in einer zweidimensionalen Anordnung (18) zu beiden Seiten des Stehgkohlleiters (4) angeordnet sind.

2. Optische Vorrichtung nach Anspruch 1, **dadurch gekennzeichnet, dass** der verteilte Reflektor (18) eine Materialstruktur oberhalb der aktiven Schicht (10) auf beiden Seiten des Stehgkohlleiters (4) aufweist.

3. Optische Vorrichtung nach Anspruch 1 oder 2, **dadurch gekennzeichnet, dass** die zweidimensionale Anordnung (18) sich in einer Ebene parallel zur aktiven Schicht (10) befindet und sich in eine Tiefe erstreckt, die mit derjenigen der aktiven Schicht (10) vergleichbar ist.

4. Optische Vorrichtung nach Anspruch 1, 2 oder 3, **dadurch gekennzeichnet, dass** die individuellen Elemente (22) Löcher sind.

5. Optische Vorrichtung nach Anspruch 4, **dadurch gekennzeichnet, dass** die Löcher (22) in einer hexagonalen Anordnung angeordnet sind.

6. Optische Vorrichtung nach Anspruch 4, **dadurch gekennzeichnet, dass** die Löcher (22) in einer quadratischen Anordnung angordnet sind.

7. Optische Vorrichtung nach einem der Ansprüche 4 bis 6, **dadurch gekennzeichnet, dass** sich die Löcher (22) in eine Tiefe erstrecken, die vergleichbar mit derjenigen der aktiven Schicht (10) ist, in einer Richtung, die senkrecht zur Ebene parallel zur aktiven Schicht (10) ist.

8. Optische Vorrichtung nach einem der Ansprüche 4 bis 6, **dadurch gekennzeichnet, dass** sich die Löcher (22) in eine Tiefe erstrecken, die vergleichbar mit derjenigen der aktiven Schicht (10) ist, in einer Richtung, die nicht senkrecht zur Ebene parallel zur aktiven Schicht (10) ist.

9. Optische Vorrichtung nach einem der Ansprüche 4 bis 8, **dadurch gekennzeichnet, dass** die Löcher (22) Bereiche sind, die im Vergleich mit der Vorrichtungsstruktur einen unterschiedlichen Brechungsindex aufweisen.

10. Optische Vorrichtung nach einem der Ansprüche 4 bis 9, **dadurch gekennzeichnet, dass** die Löcher (22) Bereiche unterschiedlicher Zu- oder Abnahme in Bezug auf die Struktur der Vorrichtung sind.

11. Optische Vorrichtung nach einem der Ansprüche 3 bis 10, **dadurch gekennzeichnet, dass** der verteilte Reflektor (18) den aktiven Bereich (10) nicht durchstößt.

12. Optische Vorrichtung nach einem der Ansprüche 3 bis 10, **dadurch gekennzeichnet, dass** der verteilte Reflektor (18) den aktiven Bereich (10) teilweise durchstößt.

13. Optische Vorrichtung nach einem der Ansprüche 3 bis 10, **dadurch gekennzeichnet, dass** der verteilte Reflektor (18) den aktiven Bereich (10) vollständig durchstößt.

14. Optische Vorrichtung nach einem der vorstehenden Ansprüche, **dadurch gekennzeichnet, dass** sich der verteilte Reflektor (18) innerhalb der Vorrichtung befindet.

15. Optische Vorrichtung nach Anspruch 14, **dadurch gekennzeichnet, dass** der verteilte Reflektor (18) sich innerhalb eines gepumpten Bereiches befindet.

16. Optische Vorrichtung nach Anspruch 14, **dadurch gekennzeichnet, dass** sich der verteilte Reflektor (18) innerhalb eines nicht gepumten Bereiches befindet.

17. Optische Vorrichtung nach einem der vorstehenden Ansprüche, **dadurch gekennzeichnet, dass** er Mittel zum Variieren der elektrischen Vorspannung oder Vorspannungen aufweist, die an die Vorrichtung angelegt werden, um eine effiziente optische Emission in einem Betrieb mit einer einzelnen Wellenlänge zu erreichen.

18. Optische Vorrichtung nach Anspruch 17, **dadurch gekennzeichnet, dass** die Emissionswellenlänge gesteuert /getuned werden kann.

19. Optische Vorrichtung nach einem der vorstehenden Ansprüche, **dadurch gekennzeichnet, dass** sie in getrennte verstärkende, absorbierende oder passive Abschnitte integriert ist.

20. Optische Vorrichtung nach Anspruch 19, **dadurch gekennzeichnet, dass** die verstärkenden oder absorbierenden Abschnitte Verstärkungs-Abschwächungsmodulation aufweisen.

21. Optische Vorrichtung nach einem der vorstehenden Ansprüche, **dadurch gekennzeichnet, dass** sie Mittel zum Pulsen durch Verstärkungsschalten, Q-Schalten oder Mode-Locking-Techniken aufweist.

## Revendications

1. Dispositif optique, comprenant une diode laser (2) qui possède un guide d'ondes nervuré (4) disposé au-dessus d'une couche active (10), et possédant un réflecteur réparti (18), **caractérisé en ce que** le réflecteur réparti se présente sous la forme d'une grille d'éléments distincts (22), où les éléments sont disposés suivant un groupement bidimensionnel sur l'un et l'autre côté du guide d'ondes nervuré (4).

2. Dispositif optique selon la revendication 1, où le réflecteur réparti (18) comprend une structure en matériau au-dessus de la couche active (10) de l'un et l'autre côté du guide d'onde nervuré (4).

3. Dispositif optique selon la revendication 1 ou 2, où le groupement bidimensionnel (18) se trouve dans un plan parallèle à la couche active (10) et se prolonge jusqu'à une profondeur qui est comparable à celle de la couche active (10).

4. Dispositif optique selon la revendication 1, 2 ou 3, où les éléments distincts (22) sont des trous.

5. Dispositif optique selon la revendication 4, où les trous (22) sont disposés suivant un groupement hexagonal.

6. Dispositif optique selon la revendication 4, où les trous (22) sont disposés suivant un groupement carré.

7. Dispositif optique selon l'une quelconque des revendications 4 à 6, où les trous (22) se prolongent jusqu'à une profondeur comparable à celle de la couche active (10) dans une direction qui est perpendiculaire au plan parallèle à la couche active (10).

8. Dispositif optique selon l'une quelconque des revendications 4 à 6, où les trous (22) se prolongent jusqu'à une profondeur comparable à celle de la couche active (10) dans une direction qui n'est pas perpendiculaire au plan parallèle à la couche active (10).

9. Dispositif optique selon l'une quelconque des revendications 4 à 8, où les trous (22) sont des régions ayant un indice de réfraction différent de celui de la structure du dispositif.

10. Dispositif optique selon l'une quelconque des revendications 4 à 9, où les trous (22) sont des régions ayant un gain ou des pertes différents de ceux de la structure du dispositif.

11. Dispositif optique selon l'une quelconque des revendications 3 à 10, où le réflecteur réparti (18) ne transperce pas la région active (10).

12. Dispositif optique selon l'une quelconque des revendications 3 à 10, où le réflecteur réparti (18) transperce partiellement la région active (10).

13. Dispositif optique selon l'une quelconque des revendications 3 à 10, où le réflecteur réparti transperce entièrement la région active (10).

14. Dispositif optique selon l'une quelconque des revendications précédentes, où le réflecteur réparti (18) se trouve à l'intérieur du dispositif.

15. Dispositif optique selon la revendication 14, où le réflecteur réparti (18) se trouve à l'intérieur d'une région pompée.

16. Dispositif optique selon la revendication 14, où le réflecteur réparti (18) se trouve à l'intérieur d'une région non pompée.

17. Dispositif optique selon l'une quelconque des revendications précédentes, où est prévu un moyen permettant de faire varier la polarisation ou les polarisations électriques appliquées au dispositif de façon à obtenir une émission optique efficace dans un fonctionnement à une seule longueur d'onde.

18. Dispositif optique selon la revendication 17, où la longueur d'onde d'émission peut être ajustée/accordée.

19. Dispositif optique selon l'une quelconque des revendications précédentes, auxquelles sont intégrées des sections séparées amplificatrice, d'absorption ou passive.

20. Dispositif optique selon la revendication 19, où les sections amplificatrices ou d'absorption présentent une modulation du gain/des pertes.

21. Dispositif optique selon l'une quelconque des revendications précédentes, où est prévu un moyen destiné à être pulsé par des techniques de commutation de gain, de commutation de facteur Q ou de verrouillage de mode.
